# EUROPÄISCHE PATENTANMELDUNG

(11) **EP 4 421 055 A1**
(43) Veröffentlichungstag der Anmeldung: **28.08.2024**
(21) Anmeldenummer: 23158215.6
(22) Anmeldetag: 23.02.2023
(51) Int. Cl.: C04B 37/02, C23C 16/02, C23F 1/12, H01L 21/00

(54) **KUPFER-KERAMIK-SUBSTRAT MIT SINTERBARER OBERSEITE**

(71) Anmelder: Heraeus Electronics GmbH & Co. KG, 63450 Hanau (DE)
(72) Erfinder: STEGMANN, Tamira, 63450 Hanau (DE); THOMAS, Sven, 63450 Hanau (DE)
(74) Vertreter: Heraeus IP

(57) **Zusammenfassung**

Die Erfindung betrifft unter anderem ein Kupfer-Keramik-Substrat. Dieses umfasst: a) einen Keramikkörper und b) eine Kupferschicht, die mit dem Keramikkörper flächig verbunden ist, wobei die Kupferschicht eine Oberseite aufweist, wobei ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt.

## Beschreibung

Die vorliegende Erfindung betrifft ein Kupfer-Keramik-Substrat, die Verwendung eines Kupfer-Keramik-Substrats und ein Verfahren zur Herstellung einer stoffschlüssigen Verbindung zwischen einem Kupfer-Keramik-Substrat und einem Elektronikbauteil.

Kupfer-Keramik-Substrate spielen eine wichtige Rolle im Bereich der Leistungselektronik. Sie sind ein maßgebliches Element beim Aufbau von elektronischen Baugruppen und sorgen für eine schnelle Ableitung hoher Wärmemengen beim Betrieb dieser Baugruppen. Kupfer-Keramik-Substrate bestehen üblicherweise aus einer Keramikschicht und einer Kupferschicht, die mit der Keramikschicht verbunden ist.

Zur Verbindung der Kupferschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Kupferfolien bei Temperaturen von etwa 650 bis 1000°C mit Keramikkörpern verbunden werden, wobei ein Aktivlot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Kupferfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper fest zu verbinden. Alternativ dazu können auch silberfreie Aktivlote zur Verbindung von Kupferfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau von elektronischen Baugruppen werden Kupfer-Keramik-Substrate üblicherweise mit Elektronikbauteilen bestückt. Dabei ist es erforderlich, dass das Elektronikbauteil mit dem Kupfer-Keramik-Substrat fest stoffschlüssig verbunden wird. Da die elektronischen Baugruppen im Betrieb oft hohen Temperaturen ausgesetzt sind, erfolgt die Verbindung des Elektronikbauteils mit dem Kupfer-Keramik-Substrat häufig über ein Sintermaterial, das Silber umfasst. Beim Sintervorgang bildet das Silber eine stoffschlüssige Verbindung zu den zu verbindenden Oberflächen des Elektronikbauteils und des Kupfer-Keramik-Substrats aus. Aufgrund des hohen Schmelzpunktes von Silber ist die entstehende Verbindung temperaturstabil. Um eine hohe Haftfestigkeit zu erreichen, wird die zu verbindende Oberfläche des Kupfer-Keramik-Substrats vor dem Sintervorgang üblicherweise mit einem Edelmetall, insbesondere Silber oder Gold, beschichtet. Dies erleichtert eine Anbindung des Sintermaterials, da das darin enthaltene Silber leicht in die edelmetallhaltige Beschichtung des Kupfer-Keramik-Substrats diffundieren kann. Nachteilig daran ist jedoch, dass die Beschichtung des Kupfer-Keramik-Substrats mit einem Edelmetall technisch aufwändig ist und weitere Fertigungsschritte erfordert. Wünschenswert wäre es daher, Elektronikbauteile mit Kupfer-Keramik-Substraten fest stoffschlüssig verbinden zu können, ohne dass die zu verbindende Oberfläche des Kupfer-Keramik-Substrats mit einer edelmetallhaltigen Beschichtung versehen ist.

Daher besteht eine Aufgabe der vorliegenden Erfindung vorzugsweise darin, ein Kupfer-Keramik-Substrat bereitzustellen, das für eine stoffschlüssige Verbindung mit einem Elektronikbauteil geeignet ist.

Eine weitere Aufgabe der vorliegenden Erfindung besteht vorzugsweise darin, ein Kupfer-Keramik-Substrat bereitzustellen, das für eine stoffschlüssige Verbindung mit einem Elektronikbauteil geeignet ist, ohne dass es einer edelmetallhaltigen Beschichtung der zu verbindenden Oberfläche des Kupfer-Keramik-Substrats bedarf.

Ein Beitrag zur Lösung dieser Aufgaben wird geleistet durch:
Ein Kupfer-Keramik-Substrat umfassend
a) einen Keramikkörper und
b) eine Kupferschicht, die mit dem Keramikkörper flächig verbunden ist, wobei die Kupferschicht eine Oberseite aufweist,
wobei
ein Energiespektrum, das bei einer Analyse der Oberseite der Kupferschicht durch Röntgenphotoelektronenspektroskopie erhalten wird,
   (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und
   (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben,
wobei das Verhältnis GF1 / GF2 wenigstens 0,25 beträgt.

Die Erfindung stellt ferner die Verwendung eines Kupfer-Keramik-Substrats und ein Verfahren zur Herstellung einer stoffschlüssigen Verbindung zwischen einem Kupfer-Keramik-Substrat und einem Elektronikbauteil bereit.

Das erfindungsgemäße Kupfer-Keramik-Substrat umfasst einen Keramikkörper.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Der Keramikkörper weist vorzugsweise eine Hauptbegrenzungsfläche auf. Als Hauptbegrenzungsfläche wird hierin vorzugsweise die Begrenzungsfläche mit dem größten Flächeninhalt bezeichnet, die mit der Kupferschicht flächig verbunden ist. Die Hauptbegrenzungsfläche liegt vorzugsweise in der Haupterstreckungsebene oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siliziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper weist vorzugsweise eine Dicke von 0,05 - 10 mm, mehr bevorzugt im Bereich von 0,1 - 5 mm und besonders bevorzugt im Bereich von 0,15 - 3 mm auf.

Das erfindungsgemäße Kupfer-Keramik-Substrat umfasst eine Kupferschicht, die mit dem Keramikkörper flächig verbunden ist, wobei die Kupferschicht eine Oberseite aufweist.

Die Kupferschicht umfasst Kupfer. Neben Kupfer umfasst die Kupferschicht vorzugsweise noch Sauerstoff, der als Kupferoxid, insbesondere als Kupfer(I)-oxid (Cu₂O) und/oder Kupfer(II)-oxid (CuO), vorliegt. Gemäß einer bevorzugten Ausführungsform umfasst die Kupferschicht daher Kupfer, Sauerstoff und unvermeidliche Verunreinigungen. Gemäß einer weiteren bevorzugten Ausführungsform beträgt der Anteil an Kupfer wenigstens 90 Gewichtsprozent, mehr bevorzugt wenigstens 95 Gewichtsprozent, noch mehr bevorzugt wenigstens 99 Gewichtsprozent und besonders bevorzugt wenigstens 99,9 Gewichtsprozent, bezogen auf das Gesamtgewicht der Kupferschicht. Gemäß einer weiteren besonders bevorzugten Ausführungsform besteht die Kupferschicht aus Kupfer, Sauerstoff und unvermeidlichen Verunreinigungen.

Die Kupferschicht weist vorzugsweise eine Dicke im Bereich von 0,01 - 10 mm, besonders bevorzugt im Bereich von 0,03 - 5 mm und ganz besonders bevorzugt im Bereich von 0,05 - 3 mm auf.

Die Kupferschicht ist mit dem Keramikkörper vorzugsweise stoffschlüssig verbunden. Gemäß einer bevorzugten Ausführungsform ist die Kupferschicht mit dem Keramikkörper durch ein Verfahren verbunden, das aus der Gruppe ausgewählt ist, die aus DCB (Direct Copper Bonding) -Verfahren und Aktivlotverfahren, insbesondere AMB (Active Metal Brazing) - Verfahren, ausgewählt ist.

Bei der Verbindung einer Kupferschicht mit einem Keramikkörper durch ein DCB-Verfahren wird vorzugsweise eine Kupferfolie mit einem Keramikkörper verbunden, wobei an der Oberfläche der Kupferfolie durch Erhitzen auf eine Temperatur im Bereich von 1025 - 1083°C, insbesondere auf eine Temperatur von 1071°C, eine Aufschmelzschicht erzeugt wird, die eine chemische Verbindung umfassend Kupfer und ein reaktives Gas, bevorzugt Sauerstoff, enthält. Diese Aufschmelzschicht bildet ein Eutektikum mit einer Schmelztemperatur unter der Schmelztemperatur von Kupfer, so dass durch Auflegen der Kupferfolie auf den Keramikkörper und durch Erhitzen eine formschlüssige Verbindung zwischen der Kupferfolie und dem Keramikkörper erzeugt wird. Ein solches Verfahren ist zum Beispiel in der deutschen Patentanmeldung DE2319854 A1 offenbart.

Bei der Verbindung einer Kupferschicht mit einem Keramikkörper durch ein AMB-Verfahren wird vorzugsweise ein Aktivlot zur Verbindung einer Kupferfolie mit einem Keramikkörper verwendet. Hierzu wird das Aktivlot vorzugsweise zwischen dem Keramikkörper und der Kupferfolie positioniert und aufgeschmolzen (besonders bevorzugt bei einer Temperatur im Bereich von 800 - 1000°C). Beim Erstarren des Aktivlotes bildet sich zwischen dem Keramikkörper und der Kupferfolie eine formschlüssige Verbindung aus. Folglich kann die Kupferschicht mit dem Keramikkörper auch über eine Verbindungsschicht flächig verbunden sein. Bei der Verbindungsschicht kann es sich zum Beispiel um eine Aktivlotschicht oder eine Diffusionsschicht handeln. Ein solches Verfahren ist zum Beispiel in der europäischen Patentanmeldung EP153618 A2 offenbart.

Die Kupferschicht ist mit dem Keramikkörper flächig verbunden. Dementsprechend ist die Kupferschicht flächig vorzugsweise mit der Hauptbegrenzungsfläche des Keramikkörpers verbunden. Die Kupferschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Kupferschicht. In diesen Fällen steht die Hauptbegrenzungsfläche des Keramikkörpers über. Darüber hinaus kann es vorgesehen sein, dass die Kupferschicht strukturiert ist. Unter Strukturierungen werden vorzugsweise Ausnehmungen in der Kupferschicht verstanden, um einzelne Abschnitte der Kupferschicht voneinander zu trennen und damit elektrisch voneinander zu isolieren. Derartige Strukturierungen werden üblicherweise durch Ätztechniken erzeugt.

Die Kupferschicht weist eine Oberseite auf. Die Oberseite der Kupferschicht ist vorzugsweise die Seite der Kupferschicht, die dem Keramikkörper, insbesondere der Hauptbegrenzungsfläche des Keramikkörpers, abgewandt ist. Dementsprechend ist die Oberseite der Kupferschicht vorzugsweise die Seite der Kupferschicht, die für die stoffschlüssige Verbindung mit einem Elektronikbauteil vorgesehen ist.

Die Oberseite der Kupferschicht ist vorzugsweise so beschaffen, dass sie mit einem Elektronikbauteil unter Verwendung von Sintermaterial, das Silber umfasst, fest stoffschlüssig verbunden werden kann. Hierzu weist die Oberseite der Kupferschicht vorzugsweise bei einer Analyse durch Röntgenphotoelektronenspektroskopie ein besonderes Energiespektrum auf.

Ein Energiespektrum, das bei einer Analyse der Oberseite der Kupferschicht durch Röntgenphotoelektronenspektroskopie erhalten wird, weist dabei auf: (i) wenigstens ein Signal S1, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt.

Das Energiespektrum umfasst vorzugsweise den Bereich von 0 eV - 1400 eV.

Das Energiespektrum weist wenigstens ein Signal S1 auf. Es kann daher auch mehrere Signale S1 aufweisen.

Das wenigstens eine Signal S1 umfasst wenigstens einen Peak P1 mit einem Maximum im Bereich von 526 eV - 538 eV. Dementsprechend ist ein Peak P1 dadurch gekennzeichnet, dass er ein Maximum im Bereich von 526 eV - 538 eV aufweist.

Das Energiespektrum kann daher zum Beispiel ein Signal S1 aufweisen, das einen oder mehrere Peaks P1 umfasst. Andererseits kann das Energiespektrum auch mehrere Signale S1 aufweisen, die jeweils einen oder mehrere Peaks P1 umfassen.

Der wenigstens eine Peak P1 weist eine Fläche PF1 auf, wobei die Flächen PF1 aller Peaks P1 des wenigstens einen Signals S1 eine Gesamtfläche GF1 ergeben. Weist das Energiespektrum zum Beispiel mehrere Signale S1 auf, die jeweils mehrere Peaks P1 aufweisen, so ergibt sich die Gesamtfläche GF1 aus der Summe der Flächen PF1 aller Peaks P1.

Ein Peak P1 mit einem Maximum im Bereich von 526 eV - 538 eV weist auf das Vorliegen von Sauerstoffspezies hin. Bei der Sauerstoffspezies kann es sich zum Beispiel um eine Spezies handeln, die aus der Gruppe ausgewählt ist, die aus Kupferoxiden (zum Beispiel Kupfer(I)-oxid, Kupfer(II)-oxid), Kupferhydroxiden und organischen Verbindungen besteht.

Die Gesamtfläche GF1 korreliert daher mit dem Anteil an Sauerstoffspezies an der Oberseite der Kupferschicht des Kupfer-Keramik-Substrats.

Das Energiespektrum weist wenigstens ein Signal S2 auf. Es kann daher auch mehrere Signale S2 aufweisen.

Das wenigstens eine Signal S2 umfasst wenigstens einen Peak P2 mit einem Maximum im Bereich von 0 eV - 1400 eV. Dementsprechend ist ein Peak P2 dadurch gekennzeichnet, dass er ein Maximum im Bereich von 0 eV - 1400 eV aufweist. Das wenigstens eine Signal S2 kann insbesondere auch wenigstens ein Signal S2 umfassen, wie es hierin als Signal S1 beschrieben ist (zum Beispiel ein Signal umfassend wenigstens einen Peak mit einem Maximum im Bereich von 526 eV - 538 eV). Folglich umfasst das Signal S2 auch das Signal S1.

Das Energiespektrum kann daher zum Beispiel ein Signal S2 aufweisen, das einen oder mehrere Peaks P2 umfasst. Andererseits kann das Energiespektrum auch mehrere Signale S2 aufweisen, die jeweils einen oder mehrere Peaks P2 umfassen.

Der wenigstens eine Peak P2 weist eine Fläche PF2 auf, wobei die Flächen PF2 aller Peaks P2 des wenigstens einen Signals S2 eine Gesamtfläche GF2 ergeben. Weist das Energiespektrum zum Beispiel mehrere Signale S2 auf, die jeweils mehrere Peaks P2 aufweisen, so ergibt sich die Gesamtfläche GF2 aus der Summe der Flächen PF2 aller Peaks P2.

Üblicherweise weist das Energiespektrum mehrere Signale S2 auf.

Das Energiespektrum weist ein Signal S2 auf, wie es hierin als Signal S1 beschrieben ist (zum Beispiel ein Signal umfassend wenigstens einen Peak mit einem Maximum im Bereich von 526 eV - 538 eV). Daher umfasst ein Signal S2 wenigstens einen Peak P2 mit einem Maximum im Bereich von 526 eV - 538 eV, der auf das Vorliegen von Sauerstoffspezies hinweist. Bei der Sauerstoffspezies kann es sich zum Beispiel um eine Spezies handeln, die aus der Gruppe ausgewählt ist, die aus Kupferoxiden, Kupferhydroxiden und organischen Verbindungen besteht.

Ferner weist das Energiespektrum vorzugsweise ein weiteres Signal S2 auf, das wenigstens einen weiteren Peak P2 umfasst.

Ein weiteres Signal S2 kann zum Beispiel auf die Cu2p-Region des Energiespektrums hinweisen und daher wenigstens einen Peak P2 umfassen, der auf das Vorliegen einer Kupferspezies hinweist. Bei der Kupferspezies kann es sich zum Beispiel um Kupfer(I)-oxid, Kupfer(II)-oxid, metallisches Kupfer oder Kupferhydroxid handeln.

Ein weiteres Signal S2 kann zum Beispiel einen Peak P2 umfassen, der auf das Vorliegen einer Kohlenstoffspezies hinweist. Bei der Kohlenstoffspezies kann es sich zum Beispiel um ein Adsorptiv an das Kupfer (zum Beispiel Kohlendioxid aus der Umgebungsluft) oder um übliche organische Verunreinigungen handeln.

Ein weiteres Signal S2 kann zum Beispiel einen Peak P2 umfassen, der auf das Vorliegen einer weiteren Spezies hinweist. Bei der weiteren Spezies kann es sich zum Beispiel um eine Stickstoffspezies handeln, die sich bei der Fertigung des Kupfer-Keramik-Substrats an der Oberseite der Kupferschicht anlagert.

Die Gesamtfläche GF2 korreliert daher mit dem Anteil an Kupferspezies in der Oberseite der Kupferschicht des Kupfer-Keramik-Substrats.

Das Verhältnis GF1 / GF2 beträgt wenigstens 0,25.

Gemäß einer bevorzugten Ausführungsform beträgt das Verhältnis GF1 / GF2 wenigstens 0,29.

Gemäß einer weiteren bevorzugten Ausführungsform beträgt das Verhältnis GF1 / GF2 nicht mehr als 0,46 und besonders bevorzugt nicht mehr als 0,40.

Gemäß einer weiteren bevorzugten Ausführungsform liegt das Verhältnis GF1 / GF2 im Bereich von 0,25 - 0,46 und besonders bevorzugt im Bereich von 0,29 - 0,40.

Überraschenderweise wurde festgestellt, dass ein Kupfer-Keramik-Substrat, das so beschaffen ist, dass ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt, mit einem Elektronikbauteil unter Verwendung von Sintermaterial, das Silber umfasst, fest stoffschlüssig verbunden werden kann.

Ohne an eine Theorie gebunden sein zu wollen, könnte dies auf die Gegenwart von Sauerstoffspezies in einer Mindestkonzentration an der Oberseite der Kupferschicht zurückzuführen sein. Fachübliche Kupfer-Keramik-Substrate aus dem Stand der Technik passivieren leicht durch Kontakt mit sauerstoffhaltiger Atmosphäre. Die Gegenwart dieser Passivierungsschicht scheint für die Ausbildung einer Sinterverbindung zwischen der Kupferschicht des Kupfer-Keramik-Substrats und einem Elektronikbauteil ausreichend zu sein. Das erfindungsgemäße Kupfer-Keramik-Substrat ist so beschaffen, dass ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt. Ein Kupfer-Keramik-Substrat, das eine Kupferschicht umfasst, deren Oberseite ein derartiges Energiespektrum aufweist, enthält einen hohen Anteil an Sauerstoffspezies. Ein derart hoher Anteil an Sauerstoffspezies scheint im Gegensatz zu einem geringeren Anteil an Sauerstoffspezies, wie er an der Oberseite der Kupferschicht von herkömmlich passivierten oder auf fachübliche Weise thermisch passivierten Kupfer-Keramik-Substraten vorliegt, völlig überraschend die Ausbildung einer Sinterverbindung zwischen der Kupferschicht des Kupfer-Keramik-Substrats und einem Elektronikbauteil zu begünstigen. Darüber hinaus hat sich überraschenderweise gezeigt, dass eine besonders hohe Haftfestigkeit erreicht werden kann, wenn das Verhältnis GF1 / GF2 im Bereich von 0,25 - 0,46 liegt.

Gemäß einer weiteren bevorzugten Ausführungsform weist ein Energiespektrum, das bei einer Analyse der Oberseite der Kupferschicht durch Röntgenphotoelektronenspektroskopie erhalten wird, wenigstens ein Signal S2 auf, das wenigstens einen Peak P2a mit einem Maximum in einem Bereich von 933,2 eV - 934,0 eV umfasst.

Ein Signal S2, das einen Peak P2a mit einem Maximum in einem Bereich von 933,2 eV - 934,0 eV umfasst, weist auf die Gegenwart von Kupfer(II)-oxid (CuO) an der Oberseite der Kupferschicht hin.

Gemäß einer bevorzugten Ausführungsform ist die Oberseite der Kupferschicht so ausgestaltet, dass ein Energiespektrum, das bei einer Analyse der Oberseite der Kupferschicht durch Röntgenphotoelektronenspektroskopie erhalten wird, wenigstens ein Signal S2 aufweist, das wenigstens einen Peak P2b mit einem Maximum im Bereich von 932,2 eV - 932,8 eV umfasst, wobei Peak P2a eine Fläche F2a einnimmt und Peak P2b eine Fläche F2b einnimmt und das Verhältnis von Fläche F2a zu Fläche F2b bei wenigstens 0,4 liegt.

Ein Signal S2, das wenigstens einen Peak P2b mit einem Maximum in einem Bereich von 932,2 eV - 932,8 eV umfasst, weist auf die Gegenwart von Kupfer(I)-oxid (Cu₂O) und/oder metallischem Kupfer (Cu(0)) an der Oberseite der Kupferschicht hin. Das Signal S2 kann folglich auch mehrere Peaks P2b aufweisen, zum Beispiel einen Peak P2b, der auf die Gegenwart von Kupfer(I)-oxid (Cu₂O) hinweist und einen Peak P2b, der auf die Gegenwart von metallischem Kupfer (Cu(0)) hinweist. Die Fläche F2b umfasst vorzugsweise die Fläche aller Peaks P2b mit einem Maximum in einem Bereich von 932,2 eV - 932,8 eV. Die Fläche F2b ist daher vorzugsweise die Summe der Flächen aller Peaks P2b mit einem Maximum in einem Bereich von 932,2 eV - 932,8 eV.

Dementsprechend korreliert die Fläche F2a des Peaks P2a mit dem Anteil an Kupfer(II)-oxid (CuO) an der Oberseite der Kupferschicht. Demgegenüber korreliert die Fläche F2b des wenigstens einen Peaks P2b mit dem Anteil an Kupfer(I)-oxid (Cu₂O) und/oder metallischem Kupfer (Cu(0)) an der Oberseite der Kupferschicht.

Gemäß einer bevorzugten Ausführungsform liegt das Verhältnis von Fläche F2a zu Fläche F2b bei wenigstens 0,5, besonders bevorzugt bei wenigstens 5,0 und ganz besonders bevorzugt bei wenigstens 8,0.

Gemäß einer weiteren bevorzugten Ausführungsform liegt das Verhältnis von Fläche F2a zu Fläche F2b bei nicht mehr als 1000, mehr bevorzugt bei nicht mehr als 500, besonders bevorzugt bei nicht mehr als 100, ganz besonders bevorzugt bei nicht mehr als 50 und insbesondere bei nicht mehr als 30.

Gemäß einer bevorzugten Ausführungsform liegt das Verhältnis von Fläche F2a zu Fläche F2b in einem Bereich von 0,4 - 1000, mehr bevorzugt in einem Bereich von 0,5 - 500, besonders bevorzugt in einem Bereich von 5,0 - 100 und ganz besonders bevorzugt in einem Bereich von 8,0 - 30.

Überraschenderweise wurde festgestellt, dass ein Kupfer-Keramik-Substrat, das so beschaffen ist, dass ein Energiespektrum, das bei einer Analyse der Oberseite der Kupferschicht durch Röntgenphotoelektronenspektroskopie erhalten wird, ein Signal aufweist, das wenigstens einen Peak P2a mit einem Maximum in einem Bereich von 933,2 eV - 934,0 eV umfasst, mit einem Elektronikbauteil unter Verwendung von Sintermaterial, das Silber umfasst, fest stoffschlüssig verbunden werden kann.

Ohne an eine Theorie gebunden sein zu wollen, könnte dies auf die Gegenwart von Kupfer(II)-oxid (CuO) an der Oberseite der Kupferschicht zurückzuführen sein. Fachübliche Kupfer-Keramik-Substrate aus dem Stand der Technik passivieren leicht durch Kontakt mit sauerstoffhaltiger Atmosphäre. Es hat sich herausgestellt, dass dabei an der Oberseite der Kupferschicht überwiegend Kupfer(I)-oxid (Cu₂O) entsteht. Die Gegenwart von Kupfer(I)-oxid (Cu₂O) scheint nicht förderlich für die Ausbildung einer Sinterverbindung zwischen der Kupferschicht des Kupfer-Keramik-Substrats und einem Elektronikbauteil zu sein. Gemäß einer bevorzugten Ausführungsform ist das Kupfer-Keramik-Substrat so beschaffen, dass ein Energiespektrum, das bei einer Analyse der Oberseite der Kupferschicht durch Röntgenphotoelektronenspektroskopie erhalten wird, wenigstens ein Signal aufweist, das wenigstens einen Peak P2a mit einem Maximum in einem Bereich von 933,2 eV - 934,0 eV umfasst. Dieser Peak P2a weist auf die Gegenwart von Kupfer(II)-oxid (CuO) hin. Im Gegensatz zu Kupfer(I)-oxid (Cu₂O) scheint Kupfer(II)-oxid (CuO) völlig überraschend die Ausbildung einer Sinterverbindung zwischen der Kupferschicht des Kupfer-Keramik-Substrats und einem Elektronikbauteil zu begünstigen.

Weiterhin wurde überraschenderweise festgestellt, dass eine besonders feste stoffschlüssige Verbindung eines Kupfer-Keramik-Substrats mit einem Elektronikbauteil unter Verwendung von Sintermaterial erreicht werden kann, wenn die Oberseite der Kupferschicht so ausgestaltet ist, dass ein Energiespektrum, das bei einer Analyse der Oberseite der Kupferschicht durch Röntgenphotoelektronenspektroskopie erhalten wird, wenigstens ein Signal aufweist, das wenigstens einen Peak P2b mit einem Maximum im Bereich von 932,2 eV - 932,8 eV umfasst, wobei Peak P2a eine Fläche F2a einnimmt und Peak P2b eine Fläche F2b einnimmt und das Verhältnis von Fläche F2a zu Fläche F2b bei wenigstens 0,4 liegt.

Ohne an eine Theorie gebunden sein zu wollen, könnte dies darauf zurückzuführen sein, dass in diesem Fall der Anteil von Kupfer(II)-oxid (CuO) zu Kupfer(I)-oxid (Cu₂O) und metallischem Kupfer (Cu(0)) an der Oberseite der Kupferschicht erhöht ist. Während ein Peak P2a mit einem Maximum bei 933,2 - 934,0 eV auf die Gegenwart von Kupfer(II)-oxid (CuO) hinweist, weist wenigstens ein Peak P2b mit einem Maximum im Bereich von 932,2 eV - 932,8 eV auf die Gegenwart von Kupfer(I)-oxid (Cu₂O) und metallischem Kupfer (Cu(0)) hin. Nachdem die Gegenwart von Kupfer(II)-oxid (CuO) sich vorteilhaft auf die Ausbildung einer stoffschlüssigen Verbindung der Oberseite des Kupfer-Keramik-Substrats mit einem Elektronikbauteil unter Verwendung von Sintermaterial auswirkt, scheint dieser Effekt umso größer zu sein, je höher der Anteil von Kupfer(II)-oxid (CuO) relativ zu Kupfer(I)-oxid (Cu₂O) und metallischem Kupfer (Cu(0)) an der Oberseite der Kupferschicht ist. Eine besonders hohe Haftfestigkeit wird dabei schließlich erreicht, wenn ein bestimmter Anteil von von Kupfer(II)-oxid (CuO) relativ zu Kupfer(I)-oxid (Cu₂O) und metallischem Kupfer (Cu(0)) nicht überschritten wird, so dass das Verhältnis von Fläche F2a zu Fläche F2b in einem Bereich von 0,4 - 1000 liegt.

Gemäß einer bevorzugten Ausführungsform umfasst das Kupfer-Keramik-Substrat eine weitere (zweite) Kupferschicht, die flächig mit dem Keramikkörper verbunden ist. Die weitere Kupferschicht ist vorzugsweise mit der der Hauptbegrenzungsfläche der Keramik abgewandten (und vorzugsweise zu dieser parallel verlaufenden) Begrenzungsfläche flächig verbunden. Die weitere (zweite) Kupferschicht kann wie die (erste) Kupferschicht beschaffen sein oder in ihrer Beschaffenheit von der (ersten) Kupferschicht abweichen. Zur Beschaffenheit der weiteren (zweiten) Kupferschicht wird auf die vorstehenden Erläuterungen Bezug genommen.

Das Verfahren zur Herstellung des erfindungsgemäßen Kupfer-Keramik-Substrats ist nicht weiter eingeschränkt.

Vorzugsweise umfasst das Verfahren zur Herstellung des erfindungsgemäßen Kupfer-Keramik-Substrats die Schritte:
(a) Bereitstellung eines Kupfer-Keramik-Substrats umfassend
   (i) einen Keramikkörper und
   (ii) eine Kupferschicht, die mit dem Keramikkörper flächig verbunden ist, wobei die Kupferschicht eine Oberseite aufweist, und
(b) Behandlung der Oberseite der Kupferschicht des Kupfer-Keramik-Substrats, so dass ein Energiespektrum, das bei einer Analyse der Oberseite der Kupferschicht durch Röntgenphotoelektronenspektroskopie erhalten wird,
   (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und
   (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben,
   wobei das Verhältnis GF1 / GF2 wenigstens 0,25 beträgt.

Das Verfahren zur Herstellung des erfindungsgemäßen Kupfer-Keramik-Substrats umfasst vorzugsweise die Bereitstellung eines Kupfer-Keramik-Substrats umfassend (i) einen Keramikkörper und (ii) eine Kupferschicht, die mit dem Keramikkörper flächig verbunden ist, wobei die Kupferschicht eine Oberseite aufweist.

Bei dem Kupfer-Keramik-Substrat kann es sich um ein fachübliches Kupfer-Keramik-Substrat handeln. Das Kupfer-Keramik-Substrat umfasst daher vorzugsweise einen Keramikkörper und eine Kupferschicht, die mit dem Keramikkörper flächig verbunden ist, wobei die Kupferschicht eine Oberseite aufweist. Zur Beschaffenheit des Kupfer-Keramik-Substrats und dessen Bestandteilen kann auf die vorstehenden Angaben Bezug genommen werden. Dabei erfüllt die Oberseite der Kupferschicht jedoch vorzugsweise nicht das Erfordernis, das ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt.

Das Verfahren zur Herstellung des erfindungsgemäßen Kupfer-Keramik-Substrats umfasst vorzugsweise die Reinigung der Oberseite der Kupferschicht des Kupfer-Keramik-Substrats.

Die Reinigung erfolgt beispielsweise dadurch, dass die Oberseite der Kupferschicht des Kupfer-Keramik-Substrats einer reduzierenden organischen Verbindung ausgesetzt wird. Bei der reduzierenden organischen Verbindung kann es sich zum Beispiel um Ameisensäure handeln.

Das Verfahren zur Herstellung des erfindungsgemäßen Kupfer-Keramik-Substrats umfasst vorzugsweise die Behandlung der Oberseite der Kupferschicht des Kupfer-Keramik-Substrats, so dass ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt.

Die Behandlung der Oberseite der Kupferschicht des Kupfer-Keramik-Substrats ist nicht weiter eingeschränkt. Die Behandlung der Oberseite der Kupferschicht des Kupfer-Keramik-Substrats umfasst vorzugsweise eine Plasmabehandlung der Oberseite der Kupferschicht oder die Abscheidung eines Kupferoxids auf der Oberseite der Kupferschicht.

Gemäß einer bevorzugten Ausführungsform umfasst die Behandlung der Oberseite der Kupferschicht des Kupfer-Keramik-Substrats eine Plasmabehandlung.

Unter Plasma wird vorzugsweise ein teilweise ionisiertes Gas verstanden, das besonders bevorzugt hochangeregte Teilchen und Radikale umfasst. Plasma ist vorzugsweise in der Lage, eine Oxidation an der Oberseite der Kupferschicht des Kupfer-Keramik-Substrats hervorzurufen. Dabei wird bevorzugt Kupfer(II)-oxid gebildet.

Gemäß einer besonders bevorzugten Ausführungsform erfolgt die Plasmabehandlung mit einem Sauerstoffplasma. Das Sauerstoffplasma kann auf fachübliche Weise erzeugt werden. Hierfür kann zum Beispiel die Plasmaanlage AP-600 (Nordson-March) verwendet werden.

Die Plasmabehandlung erfolgt vorzugsweise bei einer Hochfrequenzleistung im Bereich von 200 - 1000 W und besonders bevorzugt bei einer Hochfrequenzleistung im Bereich von 500 - 700 W, so zum Beispiel bei 600 W.

Die Plasmabehandlung erfolgt vorzugsweise bei einer Frequenz im Bereich von 10 - 15 MHz und besonders bevorzugt bei einer Frequenz im Bereich von 13 - 14 MHz, so zum Beispiel bei einer Frequenz von 13,56 MHz.

Gemäß einer bevorzugten Ausführungsform erfolgt die Plasmabehandlung bei einem Basisdruck im Bereich von 0,1 - 0,5 mbar und besonders bevorzugt bei einem Basisdruck im Bereich von 0,2 - 0,4 mbar.

Gemäß einer bevorzugten Ausführungsform erfolgt die Plasmabehandlung bei einem Prozessdruck im Bereich von 0,5 - 1,5 mbar und besonders bevorzugt bei einem Prozessdruck im Bereich von 0,7 - 1,0 mbar.

Gemäß einer bevorzugten Ausführungsform liegt der Sauerstoffgasfluss nach Erreichen des Basisdruckes im Bereich von 50 - 150 Standardkubikzentimetern pro Minute, so zum Beispiel bei 100 - 150 Standardkubikzentimetern pro Minute.

Die Plasmabehandlung erfolgt vorzugsweise für einen Zeitraum im Bereich von 100 - 1000 s und besonders bevorzugt für einen Zeitraum im Bereich von 150 - 900 s.

Gemäß einer weiteren bevorzugten Ausführungsform umfasst die Behandlung der Oberseite der Kupferschicht des Kupfer-Keramik-Substrats die Abscheidung eines Kupferoxids auf der Oberseite der Kupferschicht. Bei dem Kupferoxid kann es sich vorzugsweise um Kupfer(II)-oxid handeln. Vorzugsweise erfolgt die Abscheidung des Kupferoxids auf der Oberseite der Kupferschicht des Kupfer-Keramik-Substrats durch ein fachübliches Verfahren, zum Beispiel durch Sputtern.

Das erfindungsgemäße Kupfer-Keramik-Substrat wird vorzugsweise zum stoffschlüssigen Verbinden mit einem Elektronikbauteil verwendet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterkomponenten besteht. Die Halbleiterkomponenten sind vorzugsweise aus der Gruppe ausgewählt, die aus Transistoren, Dioden und integrierten Schaltkreisen besteht.

Gemäß einer bevorzugten Ausführungsform umfasst das Elektronikbauteil eine metallische Beschichtung. Die metallische Beschichtung kann dazu dienen, eine leichtere Anbindung des Elektronikbauteils an das Kupfer-Keramik-Substrat über das Sintermaterial zu ermöglichen. Die metallische Beschichtung kann vorzugsweise verschiedene Lagen umfassen. Vorzugsweise umfasst die metallische Beschichtung des Elektronikbauteils ein Edelmetall. Das Edelmetall kann dabei Teil einer edelmetallhaltigen Legierung sein. Vorzugsweise umfasst das Edelmetall wenigstens ein Element, das aus der Gruppe ausgewählt ist, die aus Gold, Silber und Palladium besteht. Gemäß einer bevorzugten Ausführungsform umfasst die metallische Beschichtung des Elektronikbauteils Silber oder eine Legierung, die wenigstens ein Element enthält, das aus der Gruppe ausgewählt ist, die aus Nickel, Palladium und Gold besteht.

Gemäß einer bevorzugten Ausführungsform ist das Kupfer-Keramik-Substrat noch zum stoffschlüssigen Verbinden mit einem Elektronikbauteil geeignet. Daher steht die Oberseite des Kupfer-Keramik-Substrats vorzugsweise nicht mit einer Verbindungsschicht in Kontakt, die eine stoffschlüssige Verbindung mit einem weiteren Bauelement, besonders bevorzugt einem Elektronikbauteil, ausgebildet hat.

Die Erfindung stellt ein Verfahren zur Herstellung einer stoffschlüssigen Verbindung zwischen einem Kupfer-Keramik-Substrat und einem Elektronikbauteil bereit, bei dem man:
a) ein Kupfer-Keramik-Substrat bereitstellt, umfassend (a) einen Keramikkörper und (b) eine Kupferschicht, die mit dem Keramikkörper flächig verbunden ist, wobei die Kupferschicht eine Oberseite aufweist, wobei ein Energiespektrum, das bei einer Analyse der Oberseite der Kupferschicht durch Röntgenphotoelektronenspektroskopie erhalten wird, (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben, wobei das Verhältnis GF1 / GF2 wenigstens 0,25 beträgt,
b) ein Elektronikbauteil bereitstellt,
c) ein Sintermaterial, das Silber umfasst, bereitstellt,
d) das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht, und
e) die Anordnung einer Behandlung unterzieht, bei der eine Sinterverbindung zwischen dem Elektronikbauteil und dem Kupfer-Keramik-Substrat entsteht.

Bei dem Verfahren wird ein Kupfer-Keramik-Substrat bereitgestellt.

Bei dem Kupfer-Keramik-Substrat handelt es sich um ein wie hierin beschriebenes Kupfer-Keramik-Substrat.

### Demnach umfasst das Kupfer-Keramik-Substrat

a) einen Keramikkörper und
b) eine Kupferschicht, die mit dem Keramikkörper flächig verbunden ist, wobei die Kupferschicht eine Oberseite aufweist,
wobei
ein Energiespektrum, das bei einer Analyse der Oberseite der Kupferschicht durch Röntgenphotoelektronenspektroskopie erhalten wird,
   (i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und
   (ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben,
wobei das Verhältnis GF1 / GF2 wenigstens 0,25 beträgt.

Bei dem Verfahren wird ein Elektronikbauteil bereitgestellt.

Zur Beschaffenheit des Elektronikbauteils kann auf die vorstehenden Angaben Bezug genommen werden.

Bei dem Verfahren wird ein Sintermaterial, das Silber umfasst, bereitgestellt.

Das Sintermaterial, das Silber umfasst, ist vorzugsweise aus der Gruppe ausgewählt, die aus Sinterpasten, Sinterfolien und Sintervorformen besteht.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste Silber und eine organische Verbindung. Es kann bevorzugt sein, dass das Silber in der Sinterpaste als Silberpartikel vorliegt. Die Silberpartikel können eine beliebige Form annehmen und daher beispielsweise als sphärische Silberpartikel, Silberflakes oder unregelmäßig geformte Silberpartikel vorliegen. Die organische Verbindung ist vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellullose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure) und Lignocerinsäure (Tetracosansäure) besteht.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Metallpartikel (insbesondere Silberpartikel) und ein Bindemittel umfasst, aufweisen, die auf einem Trägersubstrat vorgetrocknet vorliegt. Die Sinterfolie kann zum Beispiel eine Dicke im Bereich von 5 - 300 µm aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Bei dem Verfahren wird ein Elektronikbauteil bereitgestellt.

Zur Beschaffenheit des Elektronikbauteils kann auf die vorstehenden Angaben Bezug genommen werden.

Bei dem Verfahren werden das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht.

Das Verfahren zum Schaffen der Anordnung ist nicht weiter eingeschränkt.

Gemäß einer bevorzugten Ausführungsform wird hierzu das Sintermaterial auf die Oberseite der Kupferschicht des Kupfer-Keramik-Substrats aufgebracht. Das Aufbringen des Sintermaterials auf die Oberseite der Kupferschicht des Kupfer-Keramik-Substrats kann durch fachübliche Verfahren erfolgen. Vorzugsweise erfolgt das Aufbringen des Sintermaterials im Fall einer Sinterpaste durch Jetten, Dispensen, Sprühen, Pinseln, Tupfen, Tauchen oder Drucken, insbesondere Siebdrucken oder Schablonendrucken, und im Fall einer Sinterfolie oder einer Sintervorform durch einfaches Auflegen. Danach kann das Elektronikbauteil mit der zu verbindenden Oberseite auf dem Sintermaterial positioniert werden, um eine Anordnung zu schaffen, bei der das Elektronikbauteil mit der Oberseite der Kupferschicht des Kupfer-Keramik-Substrats über das Sintermaterial in Kontakt steht.

Gemäß einer alternativen bevorzugten Ausführungsform wird das Sintermaterial auf die zu verbindende Oberseite des Elektronikbauteils aufgebracht. Das Aufbringen des Sintermaterials auf die die zu verbindende Oberseite des Elektronikbauteils kann durch fachübliche Verfahren erfolgen. Vorzugsweise erfolgt das Aufbringen des Sintermaterials im Fall einer Sinterpaste durch Jetten, Dispensen, Sprühen, Pinseln, Tupfen, Tauchen oder Drucken, insbesondere Siebdrucken oder Schablonendrucken, und im Fall einer Sinterfolie oder einer Sintervorform durch einfaches Auflegen. Danach kann das Kupfer-Keramik-Substrat mit der Oberseite der Kupferschicht auf dem Sintermaterial positioniert werden, um eine Anordnung zu schaffen, bei der das Elektronikbauteil mit der Oberseite der Kupferschicht des Kupfer-Keramik-Substrats über das Sintermaterial in Kontakt steht.

Bei dem Verfahren wird die Anordnung einer Behandlung unterzogen, bei der eine Sinterverbindung zwischen dem Elektronikbauteil und dem Kupfer-Keramik-Substrat entsteht.

Gemäß einer bevorzugten Ausführungsform erfolgt die Behandlung durch eine Temperaturbeaufschlagung und/oder eine Druckbeaufschlagung.

Bei einer Temperaturbeaufschlagung wird die Anordnung vorzugsweise einer Temperatur im Bereich von 150 - 350°C, mehr bevorzugt einer Temperatur im Bereich von 180 - 280°C und besonders bevorzugt einer Temperatur im Bereich von 200 - 250°C ausgesetzt.

Bei einer Druckbeaufschlagung wird die Anordnung vorzugsweise einem Druck im Bereich von >0 - 300 bar, besonders bevorzugt einem Druck im Bereich von 0,1 - 30 bar und ganz besonders bevorzugt einem Druck im Bereich von 0,2 - 10 bar ausgesetzt.

Bei dem Verfahren entsteht eine Sinterverbindung und damit eine stoffschlüssige Verbindung zwischen dem Elektronikbauteil und dem Kupfer-Keramik-Substrat.

### Methodenbeschreibung:

Die Analyse der Oberseite der Kupferschicht durch Röntgenphotoelektronenspektroskopie, die Aufnahme des Energiespektrums und die Auswertung des Energiespektrums erfolgen dabei vorzugsweise gemäß dem folgenden Verfahren:
Zur Vorbereitung der Messungen mittels Röntgenphotoelektronenspektroskopie wurden die Kupfer-Keramik-Substrate mit einem Seitenschneider in Probenstücke mit den Kantenlängen 0,9 (+/- 0,1) cm x 1,4 (+/- 0,1) cm zerteilt. Fransen an den Kanten nach dem Zurechtschneiden wurden mittels eines Skalpells entfernt, um eine gerade Auflagefläche zu gewährleisten. Die Reinigung der Probenstücke von Staub erfolgte durch Abpusten mit Stickstoffgas. Die Probenstücke wurden mittels nicht-leitendem Klebeband auf einen Probenhalter geklebt.

Die Aufnahme der Röntgenphotoelektronenspektren erfolgte an einem PHI VersaProbe4 von Physical Electronics mit einer Al-Anode (monochromatische Kα = 1,487 keV) als Quelle. Zunächst wurden von den Probenstücken Übersichtsspektren (Bereich 0 - 1400 eV) aufgenommen. Aus den Übersichtsspektren wurde auf die an der untersuchten Oberseite der Probenstücke enthaltenen Elemente geschlossen. Anschließend wurden von den Probenstücken in den Energiebereichen, in denen Signale im Übersichtsspektrum identifiziert werden konnten, Detailspektren aufgenommen. Für die Aufnahme der Detailspektren wurde ein Röntgenstrahl (200 µm Durchmesser; 50 W bei 15 kV; Messzeit: 25 - 40 min (zum Beispiel: 30 min); 20 ms Integrationszeit pro Messpunkt) bei aktivierter Peak-To-Noise-Einstellung und unter Verwendung eines Neutralisators (Kombination aus Ar+ und e-, bei geringer kinetischer Energie) eingesetzt.

Die Auswertung der Spektren erfolgte mit der Analysesoftware CasaXPS (Version 2.3.224PR1.0; Casa Software Ltd.). Die C-C/C-H-Komponente des C 1s-Signals (ubiquitär vorhanden) wurde als Referenz auf den Wert 284,8 eV normiert und die Bindungsenergien der Detailspektren wurden entsprechend verschoben. Zur Untergrundkorrektur wurde eine Shirley-Funktion verwendet. Aus den erhaltenen Signalen wurden mittels der Analysesoftware Peaks generiert. Die Anzahl an Peaks wurde basierend auf Fitmodellen aus der Literatur (XPS-NIST-Datenbank) angepasst und die Peaks wurden Elementen bzw. Verbindungen zugeordnet. Mit der Analysesoftware wurden für die generierten Peaks die Peakflächen unter Berücksichtigung der Relativen Empfindlichkeitsfaktoren berechnet.

### Ausführungsbeispiele:

Die vorliegende Erfindung wird nachstehend durch Ausführungsbeispiele näher beschrieben, die jedoch nicht als einschränkend verstanden werden sollen.

### Beispiel 1:

Für das Beispiel wurde ein Kupfer-Keramik-Substrat mit der Abmessung 27 x 38 mm verwendet, bei dem ein Keramikkörper aus einer Siliziumnitridkeramik beidseitig mit jeweils einer Kupferschicht mit einer Dicke von 0,3 mm über ein AMB (Active Metal Brazing) - Verfahren, verbunden war (Condura^{®}.prime AMB, oberseitig unbeschichtet, Heraeus).

Das Kupfer-Keramik-Substrat wurde zunächst gereinigt. Hierzu wurde das Kupfer-Keramik-Substrat in der Kammer einer Lötanlage (PINK Vadu 200) zunächst Vakuum, dann Ameisensäure bei einem Atmosphärendruck von 500 mbar und einer Temperatur von 180 °C und anschließend Stickstoff ausgesetzt.

Das Kupfer-Keramik-Substrat wurde anschließend einer Plasmabehandlung mit einem Sauerstoffplasma unterzogen. Hierzu wurde das Kupfer-Keramik-Substrat mittig auf den oberen Probenträger der Plasmaanlage (AP-600 (Nordson-March) gelegt. Die Plasmabehandlung erfolgte für eine Prozesszeit von 180 s bei einer Leistung von 600 W, einer Frequenz von 13,56 Hz, einem Basisdruck von 0,3 mbar und einem Prozessdruck von 0,9 mbar. Nach der Plasmabehandlung wurde das Kupfer-Keramik-Substrat aus der Plasmaanlage entnommen.

Die Oberseite der Kupferschicht der Kupfer-Keramik-Substrate wurde mittels Röntgenphotoelektronenspektroskopie gemäß dem vorstehend beschriebenen Verfahren analysiert. Die Ergebnisse sind in Tabelle 1 dargestellt.

Anschließend wurde das Kupfer-Keramik-Substrat mit Siliziumchips bestückt. Hierzu wurde das Kupfer-Keramik-Substrat mithilfe einer 150 µm dicken Druckschablone und eines Rakels mit einer Sinterpaste (ASP 338-28, Heraeus) bedruckt. Die Sinterpaste wurde in einem Konvektionsofen bei 140 °C für 20 min in einer Stickstoffatmosphäre mit einem Restsauerstoffgehalt von 50 ppm vorgetrocknet und anschließend abgekühlt. Auf der vorgetrockneten Sinterpaste wurden Siliziumchips mit der Abmessung 4 x 4 mm (Dicke = 250 µm), die eine unterseitige Metallisierung (100 nm Aluminium, 50 nm Titan, 100 nm Nickel und schließlich 700 nm Silber) aufwiesen, positioniert. Das Sintern erfolgte in einer PINK Sinterpresse (Fa. Pink, Wertheim) für eine Dauer von 3 min in einer Stickstoffatmosphäre bei einem Druck von 20 MPa und einer Temperatur von 250°C.

### Beispiel 2:

Beispiel 2 wurde analog zu Beispiel 1 durchgeführt, wobei im Unterschied zu Beispiel 1 jedoch die Plasmabehandlung für 300 s statt für 180 s erfolgte.

### Beispiel 3:

Beispiel 3 wurde analog zu Beispiel 1 durchgeführt, wobei im Unterschied zu Beispiel 1 jedoch die Plasmabehandlung für 420 s statt für 180 s erfolgte.

### Beispiel 4:

Beispiel 4 wurde analog zu Beispiel 1 durchgeführt, wobei im Unterschied zu Beispiel 1 jedoch die Plasmabehandlung für 600 s statt für 180 s erfolgte.

### Beispiel 5:

Beispiel 5 wurde analog zu Beispiel 1 durchgeführt, wobei im Unterschied zu Beispiel 1 jedoch die Plasmabehandlung für 780 s statt für 180 s erfolgte.

### Vergleichsbeispiel 1:

Vergleichsbeispiel 1 wurde analog zu Beispiel 1 durchgeführt, wobei im Unterschied zu Beispiel 1 jedoch auf die Reinigung mit Ameisensäure und die Plasmabehandlung verzichtet wurde.

### Vergleichsbeispiel 2:

Vergleichsbeispiel 1 wurde analog zu Beispiel 1 durchgeführt, wobei im Unterschied zu Beispiel 1 jedoch auf die Plasmabehandlung verzichtet wurde.

### Auswertung:

Die in den Beispielen 1 - 5 und den Vergleichsbeispielen 1 und 2 erhaltenen Bauteile wurden auf mechanische Haftfestigkeit der Siliziumchips auf den Kupfer-Keramik-Substraten untersucht. Dazu wurde ein Schertest unter Verwendung des Bondtesters Nordson Dage 4000 Plus (Fa. Nordson, USA) durchgeführt. Das Bauteil wurde hierzu zunächst in die Vorrichtung eingespannt. Für die Testung wurde ein Schermeißel mit einer Breite von 6 mm aus Stahl verwendet, der mit ansteigender Kraft auf das Bauteil einwirkte, bis es zu einem Ablösen der Siliziumchips von den Kupfer-Keramik-Substraten kam. Die Kraft, bei der sich die Siliziumchips lösten, wurde als Scherfestigkeit bezeichnet und zur Bewertung der Haftfestigkeit in N/mm² angegeben. Für die Auswertung wurden jeweils 16 Werte erzeugt und der Mittelwert für die Scherfestigkeit gebildet. Die Ergebnisse sind in Tabelle 1 angegeben:

**Tabelle 1: Ergebnisse zur Untersuchung der Haftfestigkeit.**

| | GF1 / GF2 | Scherfestigkeit in N/mm² |
|---|---|---|
| Beispiele | | |
| 1 | 0,35 | 76,6 |
| 2 | 0,37 | 78,7 |
| 3 | 0,39 | 76,2 |
| 4 | 0,39 | 74,5 |
| 5 | 0,43 | 59,0 |

| Vergleichsbeispiele | | |
|---|---|---|
| 1 | 0,23 | 54,9 |
| 2 | 0,24 | 57,6 |

Die Ergebnisse zeigen, dass die erfindungsgemäßen Kupfer-Keramik-Substrate der Beispiele 1 - 5 den Kupfer-Keramik-Substraten der Vergleichsbeispiele 1 und 2 in Bezug auf die Eignung, eine feste stoffschlüssige Verbindung zu einem Elektronikbauteil zu schaffen, deutlich überlegen sind.

## Patentansprüche

1. Kupfer-Keramik-Substrat umfassend
a) einen Keramikkörper und
b) eine Kupferschicht, die mit dem Keramikkörper flächig verbunden ist, wobei die Kupferschicht eine Oberseite aufweist,
**dadurch gekennzeichnet, dass**
ein Energiespektrum, das bei einer Analyse der Oberseite der Kupferschicht durch Röntgenphotoelektronenspektroskopie erhalten wird,
(i) wenigstens ein Signal S1 aufweist, das wenigstens einen Peak P1 mit einem Maximum im Bereich von 526 eV - 538 eV umfasst, wobei der wenigstens eine Peak P1 eine Fläche PF1 aufweist, wobei die Flächen PF1 aller Peaks P1 des wenigstens einen Signals S1 eine Gesamtfläche GF1 ergeben, und
(ii) wenigstens ein Signal S2 aufweist, das wenigstens einen Peak P2 mit einem Maximum im Bereich von 0 eV - 1400 eV umfasst, wobei der wenigstens eine Peak P2 eine Fläche PF2 aufweist, wobei die Flächen PF2 aller Peaks P2 des wenigstens einen Signals S2 eine Gesamtfläche GF2 ergeben,
wobei das Verhältnis GF1 / GF2 wenigstens 0,25 beträgt.

2. Kupfer-Keramik-Substrat gemäß Anspruch 1, **dadurch gekennzeichnet, dass** das Verhältnis GF1 / GF2 im Bereich von 0,25 - 0,46 liegt.

3. Kupfer-Keramik-Substrat gemäß Anspruch 2, **dadurch gekennzeichnet, dass** das Verhältnis GF1 / GF2 im Bereich von 0,29 - 0,40 liegt.

4. Kupfer-Keramik-Substrat gemäß einem der vorangegangenen Ansprüche, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

5. Verwendung eines Kupfer-Keramik-Substrats gemäß einem der Ansprüche 1 - 4 zum stoffschlüssigen Verbinden mit einem Elektronikbauteil.

6. Verfahren zur Herstellung einer stoffschlüssigen Verbindung zwischen einem Kupfer-Keramik-Substrat und einem Elektronikbauteil, bei dem man:
a) ein Kupfer-Keramik-Substrat gemäß Anspruch 1 bereitstellt,
b) ein Elektronikbauteil bereitstellt,
c) ein Sintermaterial, das Silber umfasst, bereitstellt,
d) das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht, und
e) die Anordnung einer Behandlung unterzieht, bei der eine Sinterverbindung zwischen dem Elektronikbauteil und dem Kupfer-Keramik-Substrat entsteht.
